(19) Europäisches Patentamt / European Patent Office / Office européen des brevets

(11) **EP 4 286 338 A1**

(12) **EUROPEAN PATENT APPLICATION**

(43) Date of publication:
**06.12.2023 Bulletin 2023/49**

(21) Application number: **22176406.1**

(22) Date of filing: **31.05.2022**

(51) International Patent Classification (IPC):
**C01G 9/00** (2006.01)   **H01L 29/786** (2006.01)
**C23C 14/00** (2006.01)

(52) Cooperative Patent Classification (CPC):
**C01G 9/00; C23C 14/00; H01L 29/7869;**
C01P 2002/02; C01P 2006/40; C01P 2006/80

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Imec VZW**
**3001 Leuven (BE)**

(72) Inventors:
• **VAN SETTEN, Michiel Jan**
**3001 Heverlee (BE)**
• **POURTOIS, Geoffrey**
**1495 Villers-la-Ville (BE)**
• **DEKKERS, Hendrik F.W.**
**3300 Tienen (BE)**
• **KAR, Gouri Sankar**
**3001 Leuven (BE)**

(74) Representative: **Winger**
**Mouterij 16 bus 101**
**3190 Boortmeerbeek (BE)**

Remarks:
Amended claims in accordance with Rule 137(2) EPC.

(54) **MIXED METAL OXIDE OF MAGNESIUM AND ZINC**

(57)   An amorphous mixed metal oxide (4) consisting of:
a) a mixture consisting of 0.40 to 0.70 parts by mole Mg, 0.30 to 0.60 parts by mole Zn, and 0.00 to 0.30 parts by mole of other elements selected from metals and metalloids,
wherein less than 0.01 parts by mole of the other elements is Al,
wherein less than 0.04 parts by mole of the other elements is Ga,
wherein the sum of all parts by mole of Mg, Zn, and the other elements amounts to 1.00,

b) oxygen, and
c) less than 0.01 parts by mole of non-metallic and non-metalloid impurities,
wherein the parts by mole are as measured by Rutherford Backscattering Spectroscopy.

FIG. 1

**Description**

**Technical field of the invention**

The present invention relates to the field of mixed metal oxides, and more in particular to mixed metal oxides of Mg and Zn for use as a channel in thin-film transistors (TFT).

**Background of the invention**

Thin film transistors are widely used in displays, memory, and logic devices. Due to their possibly intensive long-term use, TFTs preferably comprise chemically stable materials. Furthermore, and more in particular, the material for the channel of a TFT preferably enables high on-currents and low off-currents, that is, a high current in the on-state and a low current in the off-state.

The process for forming TFTs is typically in the back-end-of-line (BEOL) stage of integrated circuit fabrication. Furthermore, in the particular application of 3D memory devices, memory cells comprising transistors, e.g., thin film transistors, are typically stacked so as to form the 3D memory device. In the process of forming a new memory cell above an existing one, it is preferably to avoid temperatures above 400°C so as not to damage any already formed memory cells. However, such deposition temperatures severely limit the type of materials that may be deposited for TFTs. Many materials typically used as channel material require higher crystallization temperatures, which disqualifies them for use in TFTs.

On the contrary, the deposition of amorphous materials does not require reaching these high thermal treatments. However, the resulting films tend to be associated with significantly lower charge carrier mobilities than their crystalline counterparts. Moreover, to be compatible with silicon technology, the materials are preferably chemically stable against forming gas anneal. Amorphous materials are intrinsically less stable than their crystalline counterparts.

The current best amorphous oxide, the metal oxide a-InGaZnO$_4$, i.e., IGZO, has, compared to typical amorphous oxides, relatively good electron mobility. This relatively good electron mobility is due to the interaction of s and d orbitals of the metal cations in a lower part of the conduction band. The strength of the bonds between the cations, and, in addition, the type of cations, drive the effective mobility of the system. The mobility of IGZO and its chemical stability are, however, not sufficiently high. IGZO has a rather low electron mobility (approximately 20 to 35 cm$^2$/(V·s)) and low chemical stability.

There is therefore a need in the art for a material and method for forming the material that solves one or more of the above problems.

**Summary of the invention**

It is an object of the present invention to provide a good mixed metal oxide of Mg and Zn. It is a further object of the present invention to provide a good method for forming the mixed metal oxide, and a transistor comprising the mixed metal oxide.

The above objective is accomplished by a method and apparatus according to the present invention.

It is an advantage of embodiments of the present invention that the mixed metal oxide may have a good electron mobility. It is an advantage of embodiments of the present invention that a channel in a transistor comprising the mixed metal oxide, may exhibit high current in the on-state, and low current in the off-state.

It is an advantage of embodiments of the present invention that the chemical stability of the mixed metal oxide may be good. It is an advantage of embodiments of the present invention that the mixed metal oxide may have good stability against annealing in a forming gas atmosphere, which is a step that is often performed in semiconductor manufacturing processes.

It is an advantage of embodiments of the present invention that elements making up the mixed metal oxide may be non-toxic. It is an advantage of embodiments of the present invention that elements making up the mixed metal oxide may be compatible with standard industrial silicon technology.

It is an advantage of embodiments of the present invention that the mixed metal oxide may be deposited at temperatures below 400°C. It is an advantage of embodiments of the present invention that the mixed metal oxide may be deposited in the back-end-of-line (BEOL) stage of semiconductor manufacturing processing. For example, silicon devices, e.g., silicon logics, may degrade at temperatures above 400°C.

It is an advantage of embodiments of the present invention that the mixed metal oxide may have good properties for use of the mixed metal oxide in transistors, such as in thin-film transistors (TFT), for example as channel material.

In a first aspect, the present invention relates to an amorphous mixed metal oxide (4) consisting of:

a) a mixture consisting of 0.40 to 0.70 parts by mole Mg, 0.30 to 0.60 parts by mole Zn, and 0.00 to 0.30 parts by mole of other elements selected from metals and metalloids, wherein less than 0.01 parts by mole of the other elements is Al, wherein less than 0.04 parts by mole of the other elements is Ga, wherein the sum of all parts by mole of Mg, Zn, and the other elements amounts to 1.00,
b) oxygen, and
c) less than 0.01 parts by mole of non-metallic and non-metalloid impurities,

wherein the parts by mole are as measured by Rutherford Backscattering Spectroscopy.

In a second aspect, the present invention relates to a method for forming the oxide (4) according to any embodiment of the first aspect, comprising depositing a magnesium oxide, a zinc oxide, and optionally one or more other oxides selected from metal oxides and metalloid oxides on a substrate (5), so as to form a mixed metal oxide (4) consisting of:

a) a mixture consisting of 0.40 to 0.70 parts by mole Mg, 0.30 to 0.60 parts by mole Zn, and 0.00 to 0.30 parts by mole of other elements selected from metals and metalloids,

wherein less than 0.01 parts by mole of the other elements is Al,
wherein less than 0.04 parts by mole of the other elements is Ga,
wherein the sum of all parts by mole of Mg, Zn, and the other elements amounts to 1.00,

b) oxygen, and
c) less than 0.01 parts by mole of non-metallic and non-metalloid impurities,
wherein the parts by mole are as measured by Rutherford Backscattering Spectroscopy.

In a third aspect, the present invention relates to a transistor comprising the oxide according to any embodiment of the first aspect.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change, and evolution of devices in this field, the present concepts are believed to represent substantial new and novel improvements, including departures from prior practices, resulting in the provision of more efficient, stable, and reliable devices of this nature.

The above and other characteristics, features, and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

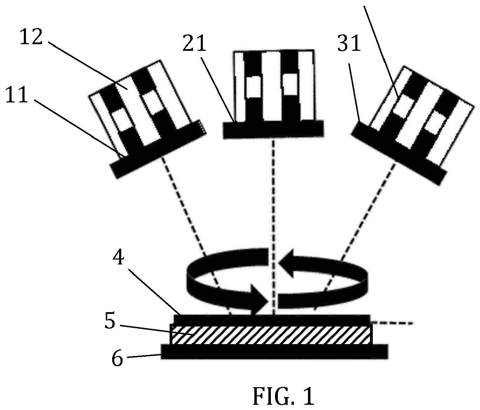

FIG. 1 is a schematic representation of a combinatorial physical vapour deposition system.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third, and the like in the description and in the claims, are used for distinguishing between similar elements and not necessarily for describing a sequence, either temporally, spatially, in ranking, or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps, or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures, or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures, and techniques have not been shown in detail in order not to obscure an understanding of this description.

Reference will be made to transistors. These are devices having a first main electrode such as a drain, a second main electrode such as a source, a channel connecting the drain and the source, and a control electrode such as a gate for controlling the flow of electrical charges between the first and second main electrodes, through the channel.

In the context of the present invention, unless otherwise stated, when an amount, e.g., in parts by mole, of an element is mentioned, the amount is as measured by Rutherford Backscattering Spectroscopy.

In the context of the present invention, a metalloid is understood to be an element selected from Arsenic, Tellurium, Germanium, Silicon, Antimony, and Boron.

In a first aspect, the present invention relates to an amorphous mixed metal oxide (4) consisting of:

a) a mixture consisting of 0.40 to 0.70 parts by mole Mg (i.e., Mg cations), 0.30 to 0.60 parts by mole Zn (i.e., Zn cations), and 0.00 to 0.30 parts by mole of other elements (i.e., cations) selected from metals and metalloids,

wherein the sum of all parts by mole of Mg, Zn, and the other elements amounts to 1.00,
wherein less than 0.01 parts by mole of the other elements is Al (i.e., Al cations),
wherein less than 0.04 parts by mole, preferably less than 0.01 parts by mole of the other elements is Ga (i.e., Ga ions)

b) oxygen (i.e., oxygen anions), and
c) less than 0.01 parts by mole of non-metallic and non-metalloid impurities,
wherein the parts by mole are as measured by Rutherford Backscattering Spectroscopy.

The inventors have found that, surprisingly, mixed metal oxides of the invention may have a combination of good electrical conductivity, and good stability, e.g., chemical stability. Without being bound by theory, the mixed metal oxide having amounts of Mg, Zn, and other elements selected from metals and metalloids according to the present invention results in a conduction band that is strongly delocalized over cation sites within the mixed metal oxide, similar to a conduction band of $a\text{-}InGaZnO_4$. This results in good electrical conductivity. Furthermore, the mixed metal oxides of the present invention have a preferred bandgap that is similar to, or slightly larger than, the bandgap of $a\text{-}InGaZnO_4$. Thereby, when, for example, the mixed metal oxide is used as a channel in a transistor, a current through the channel in an off-state of the transistor may be small. Similarly to $a\text{-}InGaZnO_4$, doping of the mixed metal oxide may be induced by an oxygen deficit, compared to a stoichiometric amount of oxygen, in the mixed metal oxide.

In embodiments, the mixture a) may consist of 0.45 to 0.65 parts by mole Mg, 0.35 to 0.55 parts by mole Zn, and 0.00 to 0.20 parts by mole of the other elements as defined in any embodiments of the first aspect.

In embodiments, the mixture a) may consist of 0.50 to 0.60 parts by mole Mg, 0.40 to 0.50 parts by mole Zn, and 0.00 to 0.10 parts by mole of the other elements as defined in any embodiments of the first aspect.

In embodiments, the mixture a) may consist of 0.53 to 0.57 parts by mole Mg, 0.43 to 0.47 parts by mole Zn, and 0.00 to 0.04 parts by mole of other elements as defined in any embodiments of the first aspect.

In embodiments, the amount of the other elements other than Mg and Zn, selected from metals and metalloids in the mixture a) is from 0.00 to 0.20 parts by mole, such as from 0.00 to 0.10 parts by mole, preferably from 0.00 to 0.05 by mole. It is an advantage of embodiments of the present invention that the other elements other than Mg and Zn, selected from metals and metalloids are present in low amounts, so that the electrical properties of the mixed metal oxide are similar to the good electrical properties and good stability of the mixed metal oxide in absence of the other elements selected from metals and metalloids.

In embodiments, less than 0.001 parts by mole of the other elements is Al. Most preferably, no Al is present.

In embodiments, less than 5 parts by mole, preferably less than 1 parts by mole, more preferably less than 0.1 part by mole, yet more preferably less than 0.01 part by mole, even more preferably less than 0.001 part by mole of the other elements is Ga. Most preferably no Ga is present.

In embodiments, the oxygen is present in an amount that is within 10 mole-%, preferably within 2 mole-%, such as within 1 mole-% of, most preferably equal to, a stoichiometric amount. In embodiments, the amount of oxygen, in moles, in the mixed metal oxide is within 10 mole-%, preferably within 2 mole-%, such as within 1 mole-% of, most preferably equal to, the sum, in moles, of the stoichiometric amount of oxygen with respect to each metal, and possibly each metalloid, in the mixture. In other words, the combination of the mixture a) and the oxygen b) of the mixed metal oxide consists of ZnO, MgO, and possibly one or more other stoichiometric metal oxides and/or one or more stoichiometric metalloid oxides, except for a possible margin of up to 10 mole-%, preferably up to 2 mole-%, such as 1 mole-%, in the amount of oxygen. In embodiments, oxygen is present in an amount in parts per mole that is within 10 mole-%, preferably within 2 mole-%, such as within 1 mole-% of, preferably equal to, the sum, in moles, of the amount of Zn, and the amount of Mg. In this last embodiment, the mixed metal oxide may additionally contain oxygen due to oxides of the other elements selected from metals and metalloids. It is an advantage of embodiments of the present invention that the presence of oxygen may facilitate the deposition of the mixed metal oxide at a low temperature.

In embodiments, the elements of the mixture consisting of Zn, Mg, and, if present, the other elements selected from metals and metalloids, are randomly mixed, i.e., are randomly distributed through the mixed metal oxide. Preferably, the mixture is homogeneous. In embodiments, the oxides of Zn, Mg, and, if present, the other elements selected from metals and metalloids, and possibly the impurities, are randomly mixed in the mixed metal oxide. That is, preferably, the oxides of Zn and Mg are randomly mixed. The mixed metal oxide preferably forms a homogeneous material. It is an advantage of these embodiments that each component of the mixed metal oxide contributes homogeneously, throughout the mixed metal oxide, to the electrical properties of the material. Thereby, the properties of the mixed metal oxide may be homogeneous.

The mixed metal oxide is in an amorphous phase. It is an advantage of the present invention that no crystallization of the mixed metal oxide is required. Crystallization may require annealing at very high temperatures, e.g., above 400°C. In embodiments, the bandgap of the mixed metal oxide may be maximum 0.6 eV higher and minimum 0.3 eV higher than the bandgap of a-InGaZnO$_4$. This is advantageous as it allows the mixed metal oxide to remain transparent in the visible region of the electromagnetic spectrum. Preferably, the mixed metal oxide is transparent in the visible region of the electromagnetic spectrum.

In embodiments, the mixed metal oxide contains less than 0.001 parts by mole of non-metallic and non-metalloid impurities. In preferred embodiments, the mixed metal oxide contains less than 0.0005 parts by mole of each non-metallic and non-metalloid impurity, e.g., hydrogen. It is an advantage of a high purity for the mixed metal oxide, that good electrical properties may be obtained.

Any features of any embodiment of the first aspect may be independently as correspondingly described for any embodiment of any of the other aspects of the present invention.

In a second aspect, the present invention relates to a method for forming the oxide according to embodiments of the first aspect, comprising depositing a magnesium oxide, a zinc oxide, and optionally one or more other oxides selected from metal oxides and metalloid oxides on a substrate, so as to form a mixed metal oxide consisting of:

a) a mixture consisting of 0.40 to 0.70 parts by mole Mg, 0.30 to 0.60 parts by mole Zn, and 0.00 to 0.30 parts by mole of other elements selected from metals and metalloids,

wherein less than 0.01 parts by mole of the other elements is Al,
wherein less than 0.04 parts by mole, preferably less than 0.01 parts by mole of the other elements is Ga,
wherein the sum of all parts by mole of Mg, Zn, and the other elements amounts to 1.00,

b) oxygen, and

c) less than 0.01 parts by mole of non-metallic and non-metalloid impurities,

wherein the parts by mole are as measured by Rutherford Backscattering Spectroscopy.

In embodiments, the deposition is performed at a temperature of at most 400 °C, preferably in a temperature range of from 200 °C to 400 °C. It is an advantage of embodiments of the present invention that the mixed metal oxide may be deposited in the BEOL stage of a manufacturing process of a semiconductor structure, and with forming stacks of transistors, e.g., in 3D memory devices, without damaging other components of the semiconductor structure. In embodiments, the substrate comprises a semiconductor device.

In embodiments, the magnesium oxide, the zinc oxide, and the optional one or more other oxides selected from metal oxides and metalloid oxides are deposited using physical vapour deposition. It is an advantage of these embodiments that physical vapour deposition may result in a homogenous, uniform mixture of the oxides. It is an advantage of these embodiments that physical vapour deposition is compatible with the BEOL stage of semiconductor manufacturing, and with forming 3D memory devices. In embodiments, the substrate comprises silicon. In embodiments, the substrate comprises a monocrystalline silicon wafer.

Typically, when a metal oxide target is used, an AC potential field is applied to the metal oxide target at a frequency of from 100 kHz to 10 MHz.

Typically, when a metal target is used, a pulsed DC potential field is applied to the metal target.

In preferred embodiments, the physical vapour deposition is performed by sputtering using simultaneously a magnesium or magnesium oxide target and a zinc oxide target. If a magnesium target is used, the sputtering is preferably performed under an oxygen flow. In embodiments, an AC potential field is applied to the zinc oxide target at a frequency of from 100 kHz to 10 MHz and a pulsed DC potential field is applied to the magnesium target.

It is an advantage of these embodiments that the deposition of the metal oxides may be efficient. When other elements selected from metal and metalloids are present in the mixture, the deposition of the oxides of these other elements may be performed by sputtering using a corresponding metal or metalloid target or using a corresponding metal oxide or metalloid oxide target.

In other embodiments, the magnesium oxide, the zinc oxide, and the optional one or more other oxides selected from metal oxides and metalloid oxides are deposited using atomic layer deposition.

Any features of any embodiment of the second aspect may be independently as correspondingly described for any embodiment of any of the other aspects of the present invention.

In a third aspect, the present invention relates to a transistor comprising the oxide according to embodiments of the first aspect.

In embodiments, the oxide according to embodiments of the first aspect forms a channel layer. It is an advantage of these embodiments that a charge mobility in the on-stage of the transistor may be high. It is an advantage of these embodiments that a charge mobility in the off-stage of the transistor may be low.

In embodiments, the transistor is a thin film transistor. In embodiments, the thin film transistor comprises the mixed metal oxide over, e.g., on, a substrate, e.g., a polymer, a glass or a silicon substrate. The substrate can be flexible or rigid. In embodiments, the thin film transistor comprises a gate material, e.g., indium tin oxide, over, e.g., on, the substrate. The substrate may comprise a semiconductor device. Preferably, the mixed metal oxide is located over the gate material, or the gate material is located over the mixed metal oxide. The gate material is typically separated from the mixed metal oxide by an insulator material, such as $SiO_2$, $Al_2O_3$, silicon nitride, or $HfO_2$. The mixed metal oxide typically contacts a drain and a source electrode, which preferably comprise a metal. The process for making thin-film transistors, e.g., channels of thin-film transistors, typically requires particularly low temperatures of formation. It is an advantage of embodiments of the present invention that the combination of good charge mobility, low formation temperature, and chemical stability, may make the oxide according to embodiments of the present invention particularly well-suited for applications in thin-film transistors.

Any features of any embodiment of the third aspect may be independently as correspondingly described for any embodiment of any of the other aspects of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Example 1: Theoretical calculations

First principles theoretical calculations, within the framework of density functional theory using the PBEsol functional, were performed to assess the electrical properties and the stability of a range of mixed metal oxides. Herein, the electrical properties are defined by the magnitude of the bandgap, and the inverse state weighted overlap (ISWO) parameter. The ISWO parameter may define the overlap of orbitals between atoms in a material. A low ISWO value represents a delocalized molecular orbital, whose atomic orbitals are continuously connected between the different atomic sites. A high ISWO value represents a highly localized and poorly connected molecular orbital. The ISWO parameter, and how it may be calculated, is further described in A. de Jamblinne de Meux et al., Method to quantify the delocalization of electronic states in amorphous semiconductors and its application to assessing charge carrier mobility of p-type amorphous oxide semiconductors, Physical Review B 97 (2018) 045208.

In this example, calculations were performed for primary, one metal and oxygen, and binary, two metals and oxygen, amorphous oxides, for 12 metals and metalloids (Mg, Al, Si, Ti, Zn, Ga, Zr, Ag, Cd, In, Sn, and Sb). Machine learning (support vector machines) was used to develop predictor functions for oxides containing up to all 12 elements and oxygen. A single objective function F(x) (shown below) was developed, that, when minimized, predicts the most promising material. By varying the weights and target gap in the objective function, it was found that mixed metal oxides consisting of Mg and Zn as metal have promising properties. Hereinbelow, results are shown for an amorphous mixed metal oxide consisting of Zn, Mg, and oxygen in a stoichiometric amount, as a function of the amount of Zn and Mg in the mixed metal oxide. Reference is made to table A. Preferably, the ISWO of the conduction band is as low as possible. A low ISWO for the conduction band may correspond to a continuous molecular orbital for the conduction band, and a potentially high charge mobility in the conduction band. For a transistor channel consisting of a material having a low ISWO for the conduction band, there may be a high current through the channel in an on-state of the transistor. Although the best results are obtained when some Al is present, the present invention focusses on alternatives to MgZnAl oxides where very little or no Al is present. This is advantageous because it simplifies the deposition process. In absence of Al, the lowest ISWO for the conduction band is found for mixed metal oxides having the composition $Mg_{0.42}Zn_{0.58}$.

Preferably, the ISWO of the valence band is as high as possible. A high ISWO for the valence band may correspond to a discontinuous molecular orbital for the valence band, and a potentially low charge mobility in the valence band. For a transistor channel consisting of a material having a high ISWO for the valence band, there may be a low current through the channel in an off-state of the transistor. A high ISWO for the valence band is found for mixed metal oxides consisting mostly of Mg.

Preferably, the bandgap of the mixed metal oxide is similar to, or a bit, e.g., 1 eV, higher than the bandgap of $a\text{-}InGaZnO_4$. It may be observed that the bandgap increases with increasing amount of Mg. For a transistor comprising a channel comprising the mixed metal oxide, the large bandgap means that the charge mobility may be low in the off state, and high in the on-state of the transistor. However, doping may be increasingly difficult for larger bandgaps.

It may also be observed that the energy of formation reduces, and, correspondingly, the stability increases, with increasing amount of Mg.

To find an optimum with respect to material properties, four parameters are defined. Herein, a bandgap is defined with respect to the bandgap of $a\text{-}InGaZnO_4$, i.e., $\Delta$-gap = G(x). Furthermore, an ISWO of the conduction band of the mixed metal oxide is defined with respect to an ISWO of the conduction band of $a\text{-}InGaZnO_4$, i.e., $\Delta\text{-}ISWO_C = I_c(x)$. In addition, an ISWO of the valence band of the mixed metal oxide is defined with respect to the ISWO of the valence band of $a\text{-}InGaZnO_4$, i.e., $\Delta\text{-}ISWO_V = I_v(x)$. Finally, a relative energy of formation of the mixed metal oxide is provided that is the difference between: the energy of formation with respect to the energy of formation of isolated atoms of the mixed metal oxide in the gas phase; and the energy of formation with respect to the energy of formation of isolated atoms of $a\text{-}InGaZnO_4$ in the gas phase. The relative energy of formation is given as $\Delta\text{-}E_{form} = E_f(x)$. Herein, a negative value means that the mixed metal oxide is calculated to be more stable than $a\text{-}InGaZnO_4$. Herein, x is for the amounts of Al and Mg in the mixed metal oxide.

Table A: Calculated electronic properties, and formation energies, for a range of compositions

| Metal content | $\Delta$-gap=$G(x)$ | $\Delta\text{-}ISWO_C=I_c(x)$ | $\Delta\text{-}ISWO_V=I_v(x)$ | $\Delta\text{-}E_{form}=E_f(x)$ |
|---|---|---|---|---|
| Mg0.39Zn0.61 | 0.31 | -0.91 | -0.99 | -0.34 |
| Mg0.41Zn0.58 | 0.36 | -0.94 | -0.8 | -0.38 |
| Mg0.44Zn0.56 | 0.37 | -0.93 | -0.56 | -0.44 |
| Mg0.47Zn0.53 | 0.4 | -0.93 | -0.33 | -0.48 |
| Mg0.47Zn0.52 | 0.42 | -0.95 | -0.27 | -0.49 |
| Mg0.49Zn0.51 | 0.42 | -0.92 | -0.09 | -0.53 |
| Mg0.51Zn0.49 | 0.44 | -0.91 | 0.08 | -0.56 |
| Mg0.53Zn0.47 | 0.46 | -0.9 | 0.3 | -0.6 |
| Mg0.56Zn0.44 | 0.49 | -0.88 | 0.62 | -0.66 |

(continued)

| Metal content | Δ-gap=$G(x)$ | Δ-ISWO$_C$=$I_c(x)$ | Δ-ISWO$_V$=$I_v(x)$ | Δ-E$_{form}$=$E_f(x)$ |
|---|---|---|---|---|
| Mg0.58Zn0.42 | 0.51 | -0.85 | 0.86 | -0.7 |
| Mg0.61Zn0.39 | 0.54 | -0.8 | 1.23 | -0.76 |
| Mg0.72Zn0.28 | 0.64 | -0.56 | 2.6 | -0.96 |
| Mg0.74Zn0.26 | 0.66 | -0.5 | 2.89 | -1 |
| Mg0.81Zn0.19 | 0.71 | -0.26 | 3.79 | -1.11 |
| Mg0.83Zn0.17 | 0.73 | -0.19 | 4.06 | -1.15 |

To derive an optimum with respect to each of the parameters, an objective function is calculated according to the following formula:

$$F(x) = (G(x) - G_t)^2 + AI_c(x) - BI_v(x) + CE_f(x)$$

wherein $G(x)$ = Δ-gap, $I_C(x)$ = Δ-ISWO$_C$, $I_V(x)$ = Δ-ISWO$_V$, and $E_f(x)$ = Δ-E$_{form}$, each as a function of composition, i.e., amount of Mg and Zn. Herein, Gt is a target bandgap, and A, B, and C are weight factors. The optimum with respect to material properties corresponds to a minimum in $F(x)$. Herein, for each of Gt and weight factors A, B, and C, the following values were used: Gt: [0, 0.25, 0.5, 0.75, 1]; A: [0.1, 0.2]; B: [0.01, 0.02]; and C: [0.0, 0.5, 1.0, 1.5]. For all these 4x2x2x4 combinations, $F(x)$ is optimized. All unique solutions are collected in Table A.

A minimum in $F(x)$ corresponds to a balance between good electrical properties and good stability. According to the present calculations, these properties compare well with, and may be better than, the corresponding properties of InGaZnO$_4$, i.e., IGZO, that is at present generally used in the field of thin-film transistors. Preferred embodiments of the present invention correspond to mixed metal oxides having an amount of Mg and Zn close to that of the optimum.

Example 2: Method for forming the mixed metal oxide

Reference is made to FIG. 1, which is a schematic representation of a combinatorial physical vapour deposition system that may be used for performing a method according to embodiments of the second aspect of the present invention, to form a mixed metal oxide according to embodiments of the first aspect of the present invention. The combinatorial physical vapour deposition system of this example may deposit oxides, i.e., MgO and ZnO. For the deposition, in the example, two sputter targets 11, 21, and an optional third sputter target 31 are mounted, each on an individual cathode 12, 22, and 32. Each of the sputter targets 11, 21, and 31 is aimed towards a substrate 5. In this example, the substrate 5 is a 300 mm diameter Si wafer. Heating of the substrate 5 may be enabled by clamping the substrate 5 to an electrically heated rotating chuck 6. The deposition is typically performed in an Ar atmosphere, although also other gases may be used. Ar may be ionized and accelerated towards each of the targets 11, 21, and 31, by application of a potential to each of the corresponding cathodes 12, 22, and 32. The impact of the Ar ions on a target 11, 21, or 31 induces a release of atoms or atom clusters from the target 11, 21, or 31. This process is referred to as 'sputtering'.

Depending on the conductance of the target 11, 21, or 31, the potential applied to the cathode 12, 22, or 32 may be oscillated. When the target 11, 21, or 31 (if present) is an oxide material, e.g., MgO or ZnO, the applied potential may oscillate at a frequency inside the radio frequency domain. When the target 11, 21, or 31 is an elemental target, e.g., Mg, a DC potential may be applied. In this example, a MgO target 11 and a ZnO target 21 are powered with an oscillating potential, and an elemental Al target 31 is powered with a pulsed DC potential. Alternatively, a ZnO target 21 may be powered with an oscillating potential and an elemental Mg target 11 may be powered with a pulsed DC potential. To obtain a fully oxidized material with elemental targets, O$_2$ may be added to the sputtering gas. The O$_2$ gas may oxidize the target during the sputtering process, thereby forming an insulating top layer on the target. In that case, a pulsed DC potential is preferably used. Pressure is regulated by the total flow, i.e., Ar flow and O$_2$ flow, and is typically in the range of a few, e.g.,1 to 10, Pa.

A uniform deposition, i.e., a uniform mixed metal oxide 4, may be achieved by optimization of the aiming angle of the cathodes 12, 22, and optionally 32, and by rotation of the substrate 5 at a high rate. Typically, a deposition rate is low enough to facilitate random mixing of the elements during deposition. Thereby, the deposition may result in a uniform film of the mixed metal oxide 4. The composition of the film 4, i.e., the amounts of Zn and Mg in the mixed metal oxide 4, may be regulated by adjusting the potential that is applied to each cathode 12 and 22.

It is to be understood that although preferred embodiments, specific constructions, and configurations, as well as materials, have been discussed herein for devices according to the present invention, various changes or modifications in form and detail may be made without departing from the scope of this invention. Steps may be added or deleted to methods described within the scope of the present invention.

## Claims

1.   An amorphous mixed metal oxide (4) consisting of:

   a) a mixture consisting of 0.40 to 0.70 parts by mole Mg, 0.30 to 0.60 parts by mole Zn, and 0.00 to 0.30 parts by mole of other elements, selected from metals and metalloids, wherein less than 0.01 parts by mole of the other elements is Al, wherein less than 0.04 parts by mole of the other elements is Ga, wherein the sum of all parts by mole of Mg, Zn, and the other elements amounts to 1.00,
   b) oxygen, and
   c) less than 0.01 parts by mole of non-metallic and non-metalloid impurities,

   wherein the parts by mole are as measured by Rutherford Backscattering Spectroscopy.

2.   The oxide (4) according to claim 1, wherein less than 0.001 parts by mole of the other elements is Al.

3.   The oxide (4) according to claim 1 or claim 2, wherein less than 0.01 part by mole of the other elements is Ga.

4.   The oxide (4) according to any one of the preceding claims, wherein the mixture a) may consist of 0.45 to 0.65 parts by mole Mg, 0.35 to 0.55 parts by mole Zn, and 0.00 to 0.20 parts by mole of the other elements selected from metals and metalloids,

   wherein less than 0.01 parts by mole of the other elements is Al,
   wherein less than 0.04 parts by mole of the other elements is Ga,
   wherein the sum of all parts by mole of Mg, Zn, and the other elements amounts to 1.00.

5.   The oxide (4) according to any one of the preceding claims, wherein the mixture a) may consist of 0.53 to 0.57 parts by mole Mg, 0.43 to 0.47 parts by mole Zn, and 0.00 to 0.04 parts by mole of the other elements selected from metals and metalloids,

   wherein less than 0.01 parts by mole of the other elements is Al,
   wherein less than 0.04 parts by mole of the other elements is Ga,
   wherein the sum of all parts by mole of Mg, Zn, and the other elements amounts to 1.00

6.   The oxide (4) according to any of the previous claims, wherein the oxygen is present in an amount that is within 10mole-% of a stoichiometric amount.

7.   A method for forming the oxide (4) according to any of the previous claims, comprising depositing a magnesium oxide, a zinc oxide, and optionally one or more other oxides selected from metal oxides and metalloid oxides on a substrate (5), so as to form a mixed metal oxide (4) consisting of:

   a) a mixture consisting of 0.40 to 0.70 parts by mole Mg, 0.30 to 0.60 parts by mole Zn, and 0.00 to 0.30 parts by mole of other elements selected from metals and metalloids, wherein less than 0.01 parts by mole of the other elements is Al, wherein less than 0.04 parts by mole of the other elements is Ga, wherein the sum of all parts by mole of Mg, Zn, and the other elements amounts to 1.00,
   b) oxygen, and
   c) less than 0.01 parts by mole of non-metallic and non-metalloid impurities,

   wherein the parts by mole are as measured by Rutherford Backscattering Spectroscopy.

8.   The method according to claim 7, wherein the deposition is performed at a temperature of at most 400 °C, preferably in a temperature range of from 200 °C to 400 °C.

9. The method according to claim 7 or 8, wherein the magnesium oxide, the zinc oxide, and the optional one or more other oxides selected from metal oxides and metalloid oxides are deposited using physical vapour deposition.

10. The method according to claim 9, wherein the physical vapour deposition is performed by sputtering using a magnesium oxide target (11) and a zinc oxide target (21).

11. The method according to claim 10, wherein a first AC potential field is applied to the magnesium oxide target (11) and to the zinc oxide target (21) at a frequency of from 100 kHz to 10 MHz.

12. The method according to any of claims 7 to 11, wherein the substrate (5) comprises silicon.

13. A transistor comprising the oxide (4) of any of claims 1 to 6.

14. The transistor according to claim 13 wherein the oxide (4) of any of claims 1 to 6 forms a channel layer.

15. The transistor according to claim 13 or 14, wherein the transistor is a thin film transistor.


**Amended claims in accordance with Rule 137(2) EPC.**

1. An amorphous mixed metal oxide (4) consisting of:

   a) a mixture consisting of 0.40 to 0.70 parts by mole Mg, 0.30 to 0.60 parts by mole Zn, and 0.00 to 0.30 parts by mole of other elements, selected from metals and metalloids, wherein less than 0.01 parts by mole of the other elements is Al, wherein less than 0.04 parts by mole of the other elements is Ga, wherein the sum of all parts by mole of Mg, Zn, and the other elements amounts to 1.00,
   b) oxygen, and
   c) less than 0.01 parts by mole of non-metallic and non-metalloid impurities,

   wherein the parts by mole are as measured by Rutherford Backscattering Spectroscopy.

2. The oxide (4) according to claim 1, wherein less than 0.001 parts by mole of the other elements is Al.

3. The oxide (4) according to claim 1 or claim 2, wherein less than 0.01 part by mole of the other elements is Ga.

4. The oxide (4) according to any one of the preceding claims, wherein the mixture a) may consist of 0.45 to 0.65 parts by mole Mg, 0.35 to 0.55 parts by mole Zn, and 0.00 to 0.20 parts by mole of the other elements selected from metals and metalloids,

   wherein less than 0.01 parts by mole of the other elements is Al,
   wherein less than 0.04 parts by mole of the other elements is Ga,
   wherein the sum of all parts by mole of Mg, Zn, and the other elements amounts to 1.00.

5. The oxide (4) according to any one of the preceding claims, wherein the mixture a) may consist of 0.53 to 0.57 parts by mole Mg, 0.43 to 0.47 parts by mole Zn, and 0.00 to 0.04 parts by mole of the other elements selected from metals and metalloids,

   wherein less than 0.01 parts by mole of the other elements is Al,
   wherein less than 0.04 parts by mole of the other elements is Ga,
   wherein the sum of all parts by mole of Mg, Zn, and the other elements amounts to 1.00

6. The oxide (4) according to any of the previous claims, wherein the oxygen is present in an amount that is within 10mole-% of a stoichiometric amount.

7. A method for forming the oxide (4) according to any of the previous claims, comprising depositing a magnesium oxide, a zinc oxide, and optionally one or more other oxides selected from metal oxides and metalloid oxides on a substrate (5), so as to form a mixed metal oxide (4) consisting of:

a) a mixture consisting of 0.40 to 0.70 parts by mole Mg, 0.30 to 0.60 parts by mole Zn, and 0.00 to 0.30 parts by mole of other elements selected from metals and metalloids, wherein less than 0.01 parts by mole of the other elements is Al, wherein less than 0.04 parts by mole of the other elements is Ga, wherein the sum of all parts by mole of Mg, Zn, and the other elements amounts to 1.00,

b) oxygen, and

c) less than 0.01 parts by mole of non-metallic and non-metalloid impurities,

wherein the parts by mole are as measured by Rutherford Backscattering Spectroscopy,

wherein the deposition is performed in a temperature range of from 200°C to 400°C; and

wherein the magnesium oxide, the zinc oxide, and the optional one or more other oxides selected from metal oxides and metalloid oxides are deposited using physical vapour deposition.

8. The method according to claim 7, wherein the physical vapour deposition is performed by sputtering using a magnesium oxide target (11) and a zinc oxide target (21).

9. The method according to claim 8, wherein a first AC potential field is applied to the magnesium oxide target (11) and to the zinc oxide target (21) at a frequency of from 100 kHz to 10 MHz.

10. The method according to any of claims 7 to 9, wherein the substrate (5) comprises silicon.

11. A transistor comprising the oxide (4) of any of claims 1 to 6.

12. The transistor according to claim 11 wherein the oxide (4) of any of claims 1 to 6 forms a channel layer.

13. The transistor according to claim 11 or 12, wherein the transistor is a thin film transistor.

FIG. 1

| | Europäisches Patentamt European Patent Office Office européen des brevets | **EUROPEAN SEARCH REPORT** | Application Number EP 22 17 6406 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/037561 A1 (UEOKA YOSHIHIRO [JP] ET AL) 3 February 2022 (2022-02-03) * paragraphs [0048], [0049]; claims; examples 4-6,9; table 4 * ----- | 1-15 | INV. C01G9/00 H01L29/786 C23C14/00 |
| A | US 2017/256676 A1 (ASADI KAMAL [NL] ET AL) 7 September 2017 (2017-09-07) * claims * ----- | 1-15 | |
| A | US 2014/326319 A1 (KIM WON MOK [KR] ET AL) 6 November 2014 (2014-11-06) * paragraph [0061]; claims * ----- | 1-15 | |
| A | US 2015/325707 A1 (SANO MASAFUMI [JP] ET AL) 12 November 2015 (2015-11-12) * paragraphs [0009], [0181]; claims * ----- | 1-15 | |
| A | JP 2006 005115 A (CASIO COMPUTER CO LTD; KOCHI PREFECTURE SANGYO SHINKO) 5 January 2006 (2006-01-05) * paragraph [0045]; claims; example 6 * ----- | 1-15 | TECHNICAL FIELDS SEARCHED (IPC) |
| A | US 2017/012138 A1 (SUZAWA HIDEOMI [JP] ET AL) 12 January 2017 (2017-01-12) * paragraph [0111] * ----- | 1-15 | C01G H01L C23C |

The present search report has been drawn up for all claims

| Place of search | Date of completion of the search | Examiner |
|---|---|---|
| Munich | 30 November 2022 | Nobis, Barbara |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 17 6406

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2022

| Patent document cited in search report | Publication date | Patent family member(s) | | Publication date |
|---|---|---|---|---|
| US 2022037561 A1 | 03-02-2022 | CN | 112888808 A | 01-06-2021 |
| | | EP | 3859046 A1 | 04-08-2021 |
| | | JP | WO2020067235 A1 | 14-10-2021 |
| | | KR | 20210075980 A | 23-06-2021 |
| | | TW | 202021157 A | 01-06-2020 |
| | | US | 2022037561 A1 | 03-02-2022 |
| | | WO | 2020067235 A1 | 02-04-2020 |
| US 2017256676 A1 | 07-09-2017 | CN | 104428910 A | 18-03-2015 |
| | | EP | 2867928 A2 | 06-05-2015 |
| | | JP | 6235580 B2 | 22-11-2017 |
| | | JP | 2015527698 A | 17-09-2015 |
| | | RU | 2015102827 A | 20-08-2016 |
| | | US | 2015340559 A1 | 26-11-2015 |
| | | US | 2016293799 A1 | 06-10-2016 |
| | | US | 2017256676 A1 | 07-09-2017 |
| | | WO | 2014002069 A2 | 03-01-2014 |
| US 2014326319 A1 | 06-11-2014 | KR | 101388432 B1 | 25-04-2014 |
| | | US | 2014326319 A1 | 06-11-2014 |
| US 2015325707 A1 | 12-11-2015 | AU | 2005302962 A1 | 18-05-2006 |
| | | AU | 2009200323 A1 | 19-02-2009 |
| | | BR | PI0517568 A | 14-10-2008 |
| | | CA | 2585190 A1 | 18-05-2006 |
| | | CA | 2708335 A1 | 18-05-2006 |
| | | CA | 2708337 A1 | 18-05-2006 |
| | | CN | 101057339 A | 17-10-2007 |
| | | CN | 102938420 A | 20-02-2013 |
| | | CN | 102945857 A | 27-02-2013 |
| | | EP | 1812969 A2 | 01-08-2007 |
| | | EP | 2453480 A2 | 16-05-2012 |
| | | EP | 2453481 A2 | 16-05-2012 |
| | | EP | 2455975 A2 | 23-05-2012 |
| | | JP | 5337849 B2 | 06-11-2013 |
| | | JP | 5589030 B2 | 10-09-2014 |
| | | JP | 2011249823 A | 08-12-2011 |
| | | JP | 2011256108 A | 22-12-2011 |
| | | JP | 2012248853 A | 13-12-2012 |
| | | KR | 20070090182 A | 05-09-2007 |
| | | KR | 20090089482 A | 21-08-2009 |
| | | RU | 2369940 C2 | 10-10-2009 |
| | | RU | 2008143340 A | 10-05-2010 |
| | | RU | 2008143344 A | 10-05-2010 |
| | | US | 2006108636 A1 | 25-05-2006 |
| | | US | 2009179199 A1 | 16-07-2009 |

EPO FORM P0459

For more details about this annex : see Official Journal of the European Patent Office, No. 12/82

**page 1 of 2**

## ANNEX TO THE EUROPEAN SEARCH REPORT
## ON EUROPEAN PATENT APPLICATION NO.

EP 22 17 6406

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2022

| Patent document cited in search report | | Publication date | Patent family member(s) | | Publication date |
|---|---|---|---|---|---|
| | | | US | 2013277672 A1 | 24-10-2013 |
| | | | US | 2015325707 A1 | 12-11-2015 |
| | | | US | 2017125605 A1 | 04-05-2017 |
| | | | WO | 2006051993 A2 | 18-05-2006 |
| JP 2006005115 | A | 05-01-2006 | JP | 4660124 B2 | 30-03-2011 |
| | | | JP | 2006005115 A | 05-01-2006 |
| US 2017012138 | A1 | 12-01-2017 | JP | 6373718 B2 | 15-08-2018 |
| | | | JP | 6978532 B2 | 08-12-2021 |
| | | | JP | 7084540 B2 | 14-06-2022 |
| | | | JP | 2015109429 A | 11-06-2015 |
| | | | JP | 2018195837 A | 06-12-2018 |
| | | | JP | 2020092280 A | 11-06-2020 |
| | | | JP | 2022028780 A | 16-02-2022 |
| | | | JP | 2022118030 A | 12-08-2022 |
| | | | US | 2015108472 A1 | 23-04-2015 |
| | | | US | 2017012138 A1 | 12-01-2017 |
| | | | US | 2018151750 A1 | 31-05-2018 |

EPO FORM P0459

For more details about this annex : see Official Journal of the European Patent Office, No. 12/82

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. DE JAMBLINNE DE MEUX et al.** Method to quantify the delocalization of electronic states in amorphous semiconductors and its application to assessing charge carrier mobility of p-type amorphous oxide semiconductors. *Physical Review B,* 2018, vol. 97, 045208